Europäisches Patentamt

European Patent Office

Office européen des brevets

(19)

(11) Publication number: **0 099 191**
**A2**

# (12) EUROPEAN PATENT APPLICATION

(21) Application number: **83303519.9**

(22) Date of filing: **17.06.83**

(51) Int. Cl.³: **G 04 F 1/00**

(30) Priority: **12.07.82 US 397621**

(43) Date of publication of application:
**25.01.84 Bulletin 84/4**

(84) Designated Contracting States:
**DE FR GB**

(71) Applicant: **HAZELTINE CORPORATION**

**Greenlawn New York 11740(US)**

(72) Inventor: **Rebovich, Steven J.**
**21-02 160th Street**
**Whitestone New York 11357(US)**

(72) Inventor: **Behrman, David**
**30 Woodlake Drive**
**East Woodbury New York 11797(US)**

(74) Representative: **Wood, Anthony Charles et al,**
**c/o MICHAEL BURNSIDE & PARTNERS 2 Serjeants' Inn**
**Fleet Street**
**London EC4Y 1HL(GB)**

(54) **Temperature stable interval timer.**

(57) A temperature compensated crystal oscillator has a permanent interval drift characteristic within a given temperature range. Output pulses from the oscillator are fed to a pulse swallower controlled by a PROM. The PROM is programmed with the interval drift characteristic information of the oscillator and is addressed by an A/D converter receiving input information from a thermistor. The thermistor provides analog signals representing the temperature of the oscillator. These signals are converted to digital information and address the PROM. The output of the PROM controls the pulse swallower to add or subtract pulses from the oscillator thereby increasing the stability of the oscillator or a given temperature range. Also disclosed is an apparatus for programming the PROM to include the drift correction information.

FIG. 3

TEMPERATURE STABLE INTERVAL TIMER

The invention relates generally to stable oscillators and, in particular, an interval timer employing a temperature controlled crystal oscillator wherein the timer is stable within a given temperature range.

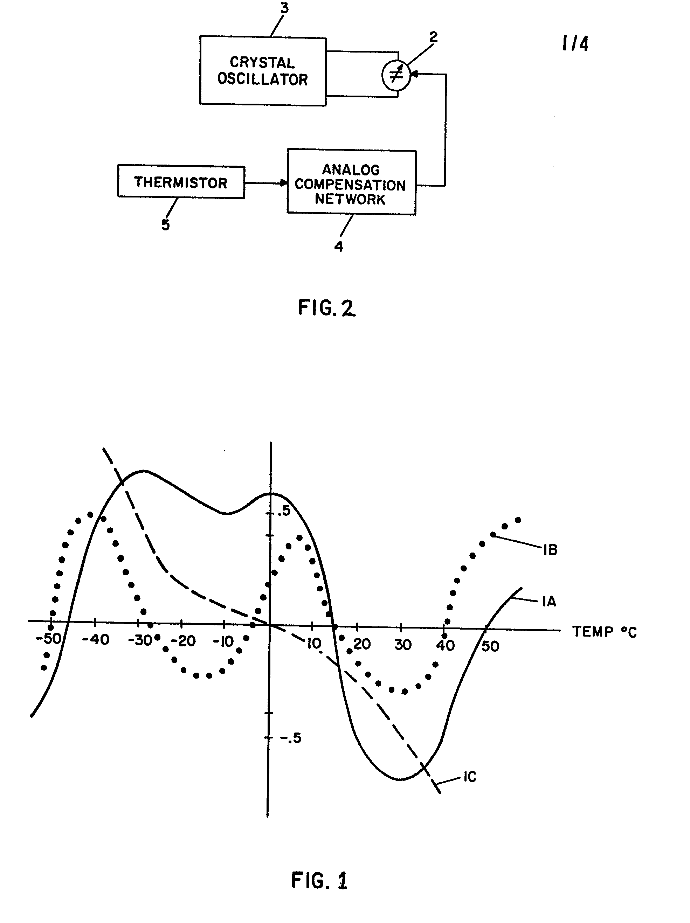

At present, the temperature stability of temperature-controlled crystal oscillators (TCXOs) is 0.5 ppm over a temperature range of $-40^{\circ}$ C to $+70^{\circ}$ C. Typical temperature versus interval drift characteristics of TCXOs are shown in Figure 1. Reference character 1A refers to a characteristic represented by a solid line in which the interval drift changes (from positive to negative or vice versa) three times within the $-50^{\circ}$ to $+50^{\circ}$ temperature range. The drift is within a range of $+0.7$ to $-0.7$ ppm and includes three peaks. Reference character 1B denotes to a temperature characteristic represented by a dotted line wherein the interval drift changes direction four times within the -50 to +50° C temperature range. The interval drift varies from +0.5 to -0.3 ppm and includes four peaks within that range. Reference character 1C denotes to a interval drift characteristic curve represented by a broken line wherein the characteristic changes from positive to negative at 0° C and is nonlinearly decreasing within the -50 to +-50° C temperature range.

It is an object of this invention to provide a stable interval timer having an interval timing stability of less than 0.5 ppm and preferably 0.1 ppm.

The invention is an interval timer which is stable within a given temperature range. The timer includes a TCXO having an output port for providing a pulsed signal at a given frequency which is dependent upon the temperature of the TCXO. First means measures the temperature of the TCXO and provides a compensating signal representing the temperature of the TCXO at a given instant in time. Second means adds or subtracts pulses in the pulsed output signal of the TCXO. Third means responsive to the first means controls the second means in accordance with the temperature of the TCXO at the given instant in time.

For a better understanding of the present invention, together with other and further objects, reference is made to the following description, taken in conjunction with the accompanying drawings, and its scope will be pointed out in the appended claims.

Figure 1 illustrates typical hypothetical temperature versus interval drift characteristics of temperature-compensated crystal oscillator.

Figure 2 is a block diagram illustrating the prior art structure for straight line correction of the interval temperature v. frequency drift characteristic of a TCXO by a varactor.

Figure 3 is a system block diagram of an interval timer according to the invention.

Figure 4 is a block diagram of a temperature cycling test set up for programming a memory for use in the invention.

Figure 5 is a block diagram of an apparatus for testing an interval timer according to the invention.

Figures 6 and 7 illustrate typical temperature versus interval temperature v. frequency drift characteristics of an interval timer in accordance with the invention.

Figure 2 illustrates structure used in the prior art to temperature compensate the temperature v. frequency drift characteristics of temperature-compensated crystal oscillators (TCXO). The interval temperature v. frequency drift characteristics of a particular TCXO are usually known or can be calculated or measured. With this information, a correction factor can be computed and implemented in order to decrease the interval drift of the TCXO. Present prior art techniques to implement such functions use the best linear approximation to the interval drift curve over a specified temperature range. As shown in Figure 2, this approximation is used to design an analog network 4 which feeds a varactor 2 in parallel with TCXO 3. Varactor 2 in turn pulls the resonant frequency of TCXO 3 to compensate for interval drifting. Varactor 2 is controlled by analog compensation network 4 provided with analog temperature information by thermistor 5.

To improve the stability of TCXO 3, the linear approximation must be changed to a curve which may be difficult to realize and implement in an analog network. Furthermore, the linear approximation results in linear correction of the drift and since most TCXO's have nonlinear drift, this correction does not match the actual TCXO drift.

The temperature v. frequency drift characteristics of a particular TCXO (i.e., its interval drift versus temperature characteristic as illustrated in Figure 1) changes slowly with respect to the age of the crystal. That is to say that if a particular TCXO has a specific drift characteristic when it is a certain age, it will always have this drift characteristic at that age. Furthermore, the drift characteristic of a TCXO varies only slightly with age of the crystal and, after aging of the crystal, long-term stability of the drift characteristic is maintained. The oscillator according to the invention takes advantage of these stable characteristics of TCXOs.

By temperature cycling particular TCXO units, drift characteristics within particular limits can be obtained. Once the drift characteristic of a particular TCXO is known, a correction factor can be computed and implemented in order to improve the stability of the TCXO. In particular, a loop feedback system is used to achieve the desired stability. A given TCXO is temperature cycled to determine its interval drift characteristics. The interval drift characteristic information is used to compute a correction factor which is stored in memory such as a PROM. The TCXO is then associated with a pulse swallower which is controlled by the PROM to correct

0099191

-6-

the output of the TCXO in accordance with its temperature. The PROM receives temperature information from a thermistor located in the vicinity of the TCXO.

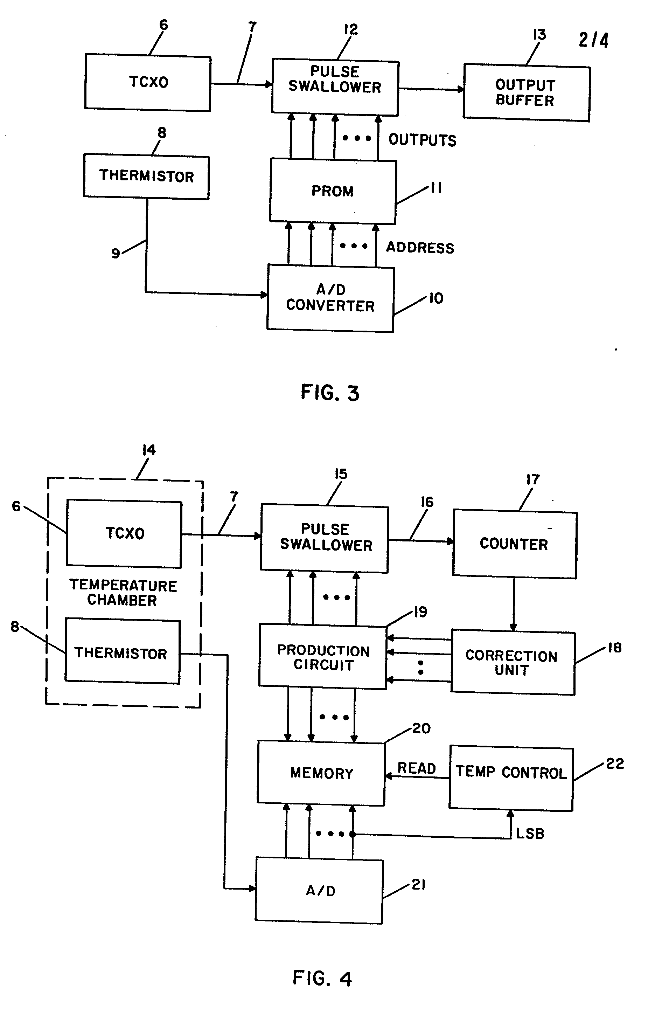

Figure 3 illustrates a system block diagram of an interval timer according to the invention. TCXO 6 has an output 7 which provides a series of pulses at a given frequency. The frequency of the pulses provided varies according to the temperature of the TCXO 6. Thermistor 8 senses the temperature of the TCXO 6 and provides an analog signal via line 9 to analog-to-digital converter 10. This analog signal from thermistor 8 represents the temperature of the TCXO 6 at a given instant. PROM 11 is programmed with the drift characteristics of TCXO 6. In particular, PROM 11 is programmed such that when addressed by converter 10 with a digital bit representing the temperature of the oscillator 6, it provides an output to pulse swallower 12. Pulse swallowers are well known in the prior art and are described in articles by J. Nichols and C. Shinn, Engineering Design News, October 1, 1970, and C. Alford, Fairchild Journal of Semiconductor Progress, Vol. 3, No. 4. The output provided to pulse swallower 12 by PROM 11 represents the number of pulses which must be added or subtracted to the output of TCXO 6 to maintain the frequency within the required limits. The output of the TCXO along with the added pulses or without the swallowed pulses is then provided to output buffer 13 for further use in interval timing.

Figure 4 illustrates a block diagram of a temperature cycling test setup for generating PROM 11 for use in an interval timer in accordance with the invention. The particular TCXO 6 which is to be calibrated and preferably the particular thermistor 8 which will monitor the temperature of the particular TCXO 6 are located in a temperature controlled chamber 14. The temperature of the chamber 14 including the TCXO 6 and thermistor 8 are stabilized at a given temperature and the output port 7 of the TCXO provides a series of pulses which are at the frequency of the TCXO for that given temperature. Initially the pulse swallower 15 is not operational so that pulses are not added or subtracted to the output of TCXO 6 and the signal provided via line 16 is the output signal from TCXO 6 and provided by line 7. Counter 17 counts the output signal pulses and provides the count to correction unit 18 which determines the number of pulses which must be added to or subtracted from the output of TCXO 6 in order to bring it within the required limits. This information is provided to production circuit 19 which instructs the pulse swallower 15 to add or subtract such pulses.

At least two techniques can be used to finally generate the PROM for use in the invention. A technician may manually read the display of counter 17 and generate a digital word that the pulse swallower 15 would use to either add or subtract pulses to compensate for any drifts. Alternatively, a temperature cycling test set as illustrated in Figure 4 may be used. This set is part of automatic correction unit 18 which automatically reads counter 17 and selects the correct digital word to be programmed into memory 20 for use by the swallower 15 in compensating for the drift. The location in memory 20 where the information is stored is addressed in the following way. The temperature in the immediate vicinity of the TCXO is sensed via thermistor 8. The output voltage of the thermistor 8 is fed to A-D converter 21 which outputs a digital word used to address memory 20. Translation of this digital word (i.e., range problems in having two words with the same address) is not encountered. Over the temperature range of operation, the thermistor circuit will be designed to operate monitonically, thereby preventing two addresses from being the same. By adjusting the threshold of converter 21, the range of the digital word output can be adjusted. Sequencing is not a problem because the addressing starts or ends and the route it takes from beginning to end makes no difference in performance, size, cost or complexity.

Because unit 18 knows where the information is stored, production circuit 19 is used to latch the information. The information is the digital word used in compensating for drift. Memory 20 reads this word when instructed by the temperature control logic 22 which reads in the correction factor when the temperature is stable and before the temperature is changed again. After the correction word is stored in memory, the temperature control logic 22 will signal a thermostat in the temperature controlled chamber 14 to change temperature (or the change may be manually performed) in order to perform the required procedure to correct the interval drift and store the next digital word in memory 20. This will continue until the entire temperature range is covered for drift correction.

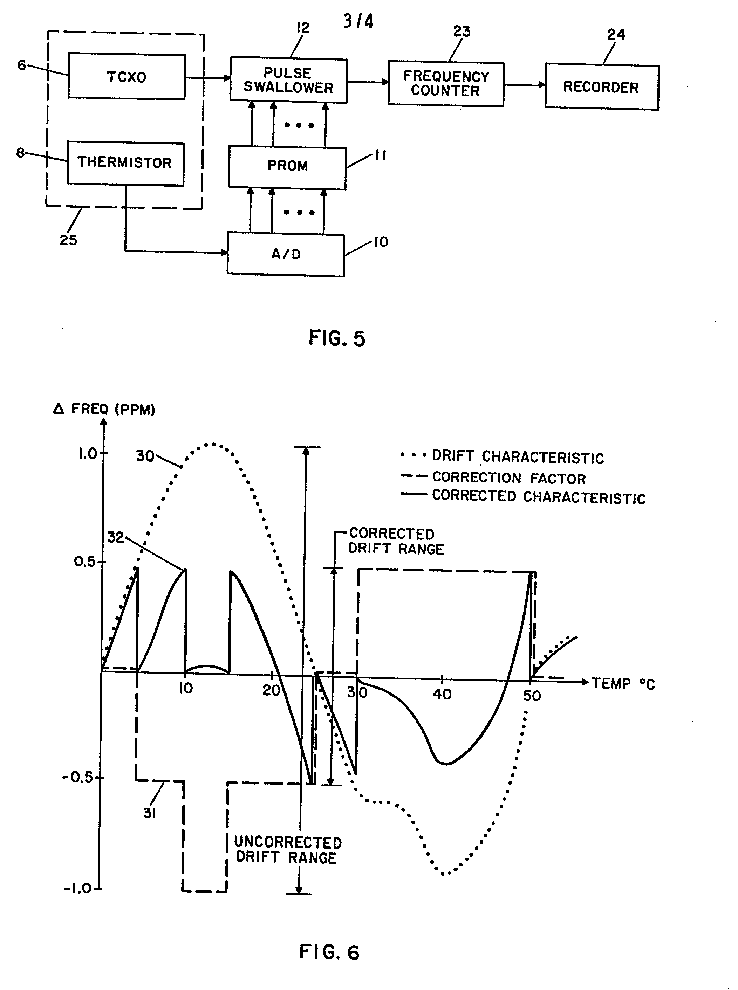

Since all of the corrections for interval drift characteristics over the temperature range are stored in memory, a PROM can be created with such stored information. A final test unit such as illustrated in Figure 5 may be used to test the interval timer according to the invention. As temperature chamber 25 cycles over its range, thermistor 8 and converter 10 address the digital word in PROM 11 used by pulse swallower 12 for interval drift correction. The rate of change of temperature in the chamber will be such that TCXO 6 has time to track the change and stabilize. External to the chamber is frequency counter 23 and recorder 24 which measure and record the frequency stability of the assembly. As noted in the above discussion of Figure 1, the temperature characteristic of a given TCXO with a given age is repeatable. This means that a correction factor can be computed. If we choose to correct for drift every $5^{\circ}$ C over the range $0^{\circ}$ C to $50^{\circ}$ C we would need eleven Bytes of information. If, in this frequency range, the TCXO 6 interval drift does not vary by more than 1.0 ppm, nor does the rate of change drift vary by more than 0.5 ppm/$5^{\circ}$ C and we wish to compensate to achieve an improved stability of 0.5 ppm, we would need two bits of information per Byte.

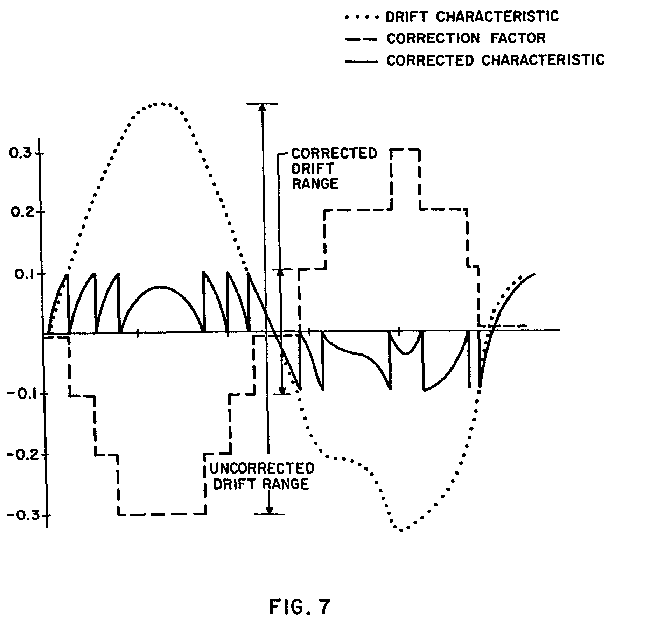

Figure 6 illustrates an interval drift curve denoted by reference character 30 and illustrated by a dotted line. Reference character 31 refers to a dashed line which illustrates the correction factor and reference character 32 refers to a solid line which illustrates the end result. If it is desired to improve this stability characteristic to 0.1 ppm, a correction factor would need to be taken every degree,

-11-

increasing the number of Bytes to 51 and the number of bits to 5 (covering 32 levels of information, which is greater than the 20 levels required). Illustrated in Figure 7 is the same information as in Figure 6 for a 0.1 ppm stability.

It is clear that the improvement in the temperature-frequency stability of a particular TCXO determines the amount of memory and production time required. Any repeatable interval drift characteristic can be compensated to any level provided the correction factor can be found and there is sufficient memory to store the information. Instability due to thermal noise (i.e., random-type noise) cannot be compensated for using this technique.

-12-

CLAIMS

Claim 1. An interval timer which is stable within a given temperature range including a temperature-controlled crystal oscillator (TCXO) having an output for providing a pulsed signal at a given frequency which is dependent upon the temperature of the TCXO; said interval timer characterized by:

(a) first means for measuring the temperature of the TCXO and providing a compensating signal representing the temperature of the TCXO at a given instant of time;

(b) second means for adding or subtracting pulses in the pulsed output signal of the TCXO; and

(c) third means, responsive to the compensating signal, for controlling the second means in accordance with the temperature of the TCXO at a given instant in time.

Claim 2. The timer of claim 1 wherein said first means comprises a thermistor providing an output signal to an analog-to-digital converter and wherein said second means is a pulse swallower circuit.

-13-

Claim 3. The timer of claim 2 wherein said third means is an addressable memory programmed with information representing the frequency of the TCXO at temperatures within the given temperature range, and said analog-to-digital converter addresses said addressable memory, said addressable memory providing control information to the pulse swallower in response to addressing provided by the converter.

Claim 4. The timer of claim 3 wherein said addressable memory is a programmable read-only memory (PROM).

FIG. 2

FIG. 1

FIG. 3

FIG. 4

FIG. 5

FIG. 6

0099191

4/4

···· DRIFT CHARACTERISTIC
—— CORRECTION FACTOR
—— CORRECTED CHARACTERISTIC

FIG. 7